# EUROPÄISCHE PATENTSCHRIFT

(11) **EP 2 062 303 B1**
(45) Veröffentlichungstag und Bekanntmachung des Hinweises auf die Patenterteilung: **21.03.2012**
(21) Anmeldenummer: 07801324.0
(22) Anmeldetag: 06.09.2007
(51) Int. Cl.: H01L 41/053

(54) **VERSPANNELEMENT UND PIEZOAKTOR MIT DEM VERSPANNELEMENT**
BRACING ELEMENT AND PIEZO ACTUATOR WITH THE BRACING ELEMENT
ELEMENT DE SERRAGE ET PIEZO-ACTIONNEUR DOTE DE L'ELEMENT DE SERRAGE

(30) Priorität: 13.09.2006 DE 102006043027
(43) Veröffentlichungstag der Anmeldung: 27.05.2009
(73) Patentinhaber: Epcos AG, 81669 München (DE)
(72) Erfinder: STOCKER, Werner, A-8792 St. Peter Freien (AT); JAKOPE, Andreas, A-8461 Ehrenhausen (AT); VERONIK, Franz, A-8510 Stainz (AT); REINISCH, Manfred, A-8522 Gr. St. Florian (AT)
(74) Vertreter: Epping - Hermann - Fischer
(86) Internationale Anmeldenummer: PCT/DE2007/001589
(87) Internationale Veröffentlichungsnummer: WO 2008/031400

(56) Entgegenhaltungen:
- DE-A1- 19 650 900
- DE-A1- 19 653 555
- DE-A1- 19 908 471
- DE-A1- 19 912 666
- US-A- 5 272 797
- Kurt Lange (Hrsg.): "Umformtechnik - Handbuch für Industrie und Wissenschaft", 1990, Springer Verlag, Berlin Heidelberg New York vol. 3, pages 578-585, * page 580 *

## Beschreibung

Es wird ein Verspannelement sowie ein Piezoaktor mit dem Verspannelement beschrieben. Auch wird ein Verspannelement zur Verspannung eines piezoelektrischen Vielschichtbauelements angegeben.

Aus DE 199 28 185 B4 ist ein Piezoelement bekannt, das mittels einer Vorspannfeder und einem darüber angeordneten Federteller an eine Grund- oder Stützplatte angedrückt wird.

Aus WO 2005/062395 ist ein Piezoaktor mit einem mit Aussparungen versehenen rohrförmigen Federelement bekannt.

Aus US 2003/034594 A1 ist ebenfalls ein Piezoaktor mit einem mit Aussparungen versehenen rohrförmigen Federelement bekannt.

Aus DE 199 08 471 A1, DE 199 12 666 A1, DE 196 53 555 A1 und US 5 272 797 A sind weitere Vorspannelemente bekannt.

Eine zu lösende Aufgabe besteht darin, Mittel anzugeben, mit denen ein Piezoaktor möglichst stabil betrieben werden kann. Eine weitere zu lösende Aufgabe besteht darin, einen stabil betreibbaren Piezoaktor anzugeben.

Diese Aufgabe wird erfindungsgemäß gelöst durch ein Vorspannelement entsprechend Anspruch 1.

Der rohrförmige Körper ist vorzugsweise nahtlos gefertigt.

Ein Bereich bzw. Abschnitt des rohrförmigen Körpers könnte ungewellt ausgeführt sein, beispielsweise als glatter Hohlzylinder.

Alle Bereiche bzw. Abschnitte des rohrförmigen Körpers können Ausnehmungen oder Durchbrüche aufweisen, welche die Elastizität bzw. Dehnbarkeit und Komprimierbarkeit des Körpers erhöhen. Dabei weisen die Ausnehmungen vorzugsweise abgerundete Formen ohne scharfe Kanten auf, wodurch die strukturelle Integrität des rohrförmigen Körpers unter mechanischer Belastung weniger beansprucht wird.

Der rohrförmige Körper ist gemäß einer bevorzugten Ausführungsform ein Wellrohr.

Der wellenförmige Bereich des Körpers kann gerade Abschnitte aufweisen. Beispielsweise könnte der wellenförmige Bereich durch Wellen mit eckigen Vertiefungen und Ausbuchtungen gebildet sein. Auch könnte der Bereich gekrümmte Abschnitte aufweisen bzw. natürliche Krümmungen wie z.B. kontinuierlich ineinander übergehende natürliche Vertiefungen und Ausbuchtungen bzw. Kurven aufweisen. Eine Kombination gerader und gekrümmter bzw. gekurvter Abschnitte kann ebenfalls vorgesehen sein.

Ein tiefer Bereich einer Welle des wellenförmigen Bereichs ist dabei dem Innenraum des rohrförmigen Körpers zugewandt bzw. durch einen eingedrückten Bereich gebildet. Ein hoher Bereich einer Welle ist dagegen dem rohrförmigen Körper abgewandt bzw. durch einen ausgebeulten Bereich des rohrförmigen Körpers gebildet.

Das Verspannelement kann einen rohrförmigen Körper umfassen, der unterschiedliche queraxiale Innendurchmesser aufweist. Der Innendurchmesser des rohrförmigen Körpers, der in der queraxialen Projektion zu einem tiefen Bereich einer Welle der Wellenform des rohrförmigen Körpers führt, ist dabei vorzugsweise geringer, als der Innendurchmesser, der in der queraxialen Projektion zu einem hohen Bereich der Welle führt.

Dort wo der Innendurchmesser des rohrförmigen Körpers einen lokalen Minimumwert hat, könnte der rohrförmige Körper als eingedrückt angesehen werden. Ein eingedrückter Bereich des rohrförmigen Körpers könnte gemäß einer Ausführungsform als umlaufende Sicke oder Einbuchtung ausgebildet sein.

Dort wo der Innendurchmesser des rohrförmigen Körpers einen lokalen Maximumwert hat, könnte der rohrförmige Körper als ausgebeult angesehen werden. Ein ausgebeulter Bereich des rohrförmigen Körpers könnte gemäß einer Ausführungsform als umlaufender Wulst ausgebildet sein.

Der rohrförmige Körper weist unterschiedliche Dicken auf. In diesem Falle entspricht ein Bereich mit einer lokalen minimalen Dicke einem tiefen Bereich einer Welle und ein Bereich mit einer lokalen maximalen Dicke einem hohen Bereich einer Welle. Tiefe Bereiche einer Welle könnten hier als Material abgetragene Bereiche des rohrförmigen Körpers angesehen werden.

Der rohrförmige Körper weist gemäß einer Ausführungsform des Verspannelements einen konstanten Innendurchmesser auf, d.h. die Innenwand des rohrförmigen Körpers ist eine ebene, glatte Fläche. Die äußere Oberfläche des rohrförmigen Körpers weist dagegen eine Wellenform bzw. eine wellenförmige Struktur auf, die durch Einbuchtungen und Beulen, vorzugsweise in einem regelmäßigen Muster, gebildet ist.

Die Außenkontur des rohrförmigen Körpers könnte kreisförmig oder in der Form eines regelmäßigen Vielecks ausgeführt sein. Die Außenkontur ist diejenige, die für einen Betrachter sichtbar gemacht wird, wenn die Längsachse des rohrförmigen Körpers in einer Linie mit der Betrachtungslinie des Betrachters liegt.

Es hat sich gezeigt, dass ein zumindest teilweise gewellter rohrförmiger Körper beim Verspannen eines piezoelektrischen Vielschichtbauelements den Vorteil hat, gegenüber einem ungewellten rohrförmigen Körper eine höhere Elastizität aufzuweisen. Somit kann der rohrförmige Körper über einen längeren Zeitraum mechanischen Belastungen standhalten. Auch kann die Anordnung der tiefen und der hohen Bereiche der Wellenform bzw. die Wellenlänge einer Welle die Steifigkeit bzw. Elastizität beeinflussen, sodass die Gestaltung der Wellenform vorteilhafterweise eine genaue Einstellung der erwünschten mechanischen Eigenschaften des rohrförmigen Körpers ermöglicht.

Auch können die mechanischen Eigenschaften des rohrförmigen Körpers durch seine gemäß einer Ausführungsform vorgesehenen variierenden Dicken alleine oder zusammen mit der Anordnung der Wellen beeinflusst bzw. eingestellt werden. Bereiche des rohrförmigen Körpers mit geringerer Dicke neigen beispielsweise gegenüber dickeren Bereichen eher dazu, unter mechanischer Druckspannung einzubiegen. Unter mechanischer Zugspannung ließen sie sich eher ausdehnen. Demgegenüber sind stärkere bzw. dickere Bereiche des rohrförmigen Körpers gegenüber mechanischer Belastung resistenter bzw. lassen sich eher weniger einknicken bzw. abflachen und verleihen dem rohrförmigen Körper eine entsprechend höhere Steifigkeit. Eine ausreichend hohe Steifigkeit spielt bei der Verspannung eines piezoelektrischen Vielschichtbauelements eine Rolle.

Der rohrförmige Körper enthält vorzugsweise ein dauerelastisches Material. Dabei weist das Material vorzugsweise eine hohe Steifigkeit auf. Gemäß einer Ausführungsform enthält der rohrförmige Körper Stahl.

Es wird außerdem ein Piezoaktor mit einem Verspannelement der beschriebenen Art angegeben. Der Piezoaktor weist.ein piezoelektrisches Vielschichtbauelement auf, welches im rohrförmigen Körper enthalten ist. Der rohrförmige Körper setzt das Vielschichtbauelement dabei unter axiale Druckspannung.

Das piezoelektrische Vielschichtbauelement weist piezoelektrisch aktivierbare keramische Schichten sowie Elektrodenschichten zur Generierung von elektrischen Feldern in den keramischen Schichten auf. Die Elektrodenschichten könnten dabei mit Zuleitungen des Piezoaktors kontaktiert sein, beispielsweise in der Form von innen- oder außenliegenden Drähten oder einer außen an der Oberfläche des Vielschichtbauelements angeordneten Außenkontaktierung bzw. Kontaktierungsschicht. Die keramischen Schichten enthalten vorzugsweise eine PZT-Keramik auf.

Die keramischen Schichten und Elektrodenschichten des piezoelektrischen Vielschichtbauelements bilden vorzugsweise einen monolithischen Körper. Dies könnte beispielsweise mittels Sintern erreicht werden.

Das piezoelektrische Vielschichtbauelement ist gemäß einer Ausführungsform stirnseitig mit je einem Gegenlager mechanisch verbunden. Dabei könnte der rohrförmige Körper stirnseitig mit den Gegenlagern mechanisch verbunden sein. Es wird bevorzugt, dass die Höhe des rohrförmigen Körpers derjenigen des Vielschichtbauelements entspricht oder geringfügig kürzer ausgeführt ist.

Die beschriebenen Gegenstände werden anhand der folgenden Ausführungsbeispiele und Figuren näher erläutert. Dabei zeigt :
- Figur 1a: einen rohrförmigen Körper mit einer umlaufenden Ausbuchtung,
- Figur 1b: einen rohrförmigen Körper mit einer umlaufenden Einbuchtung,
- Figur 2: einen rohrförmigen Körper mit variierender Wandstärke,
- Figur 3: ein Wellrohr,
- Figur 4: ein in einem Wellrohr angeordnetes elektrisches Vielschichtbauelement.

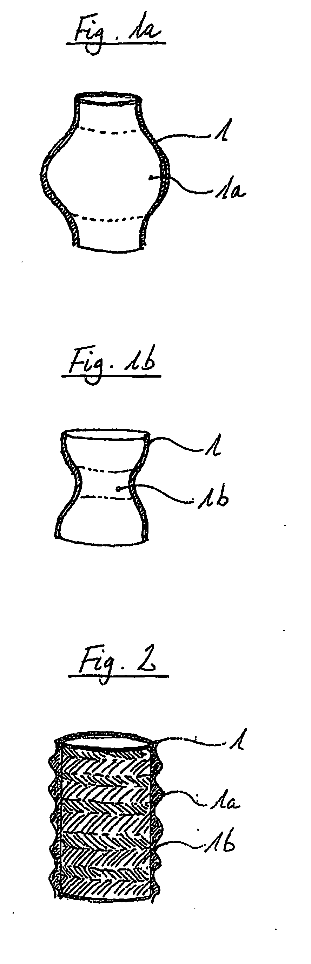

Figur 1a zeigt beispeilhaft ein Rohr 1 mit einem im Bereich 1a vergrößerten Durchmesser, der auch als umlaufende Ausbuchtung oder Wulst verstanden werden kann. Das Rohr weist eine einfache Wellenform auf, die je nach Betrachtung an der oberen oder an der unteren Stirnseite des Rohrs mit einem kleineren Rohrdurchmesser als die Ausbuchtung 1a beginnt. Die Wandstärke des Rohrs ist vorzugsweise konstant oder wird vorzugsweise so konstant wie möglich ausgeführt. Die umlaufende Ausbuchtung wird vorzugsweise mittels eines Innendruck-Umformverfahrens erzeugt. Das Verfahren umfasst einen Vorgang, bei dem die Innenwand des Rohrs mittels mechanischen Drucks, beispielsweise unter Verwendung eines geeigneten Gegenstands, nach außen ausgebeult wird. Die Ausbuchtung umläuft das Rohr vorzugsweise ganz. Am Scheitelbereich der gezeigten Welle, d.h. in dem Bereich, wo das Rohr seinen größten Durchmesser aufweist, ist das Rohr unter mechanischer Druckspannung geneigt, leichter einzubiegen bzw. geringfügig nachzugeben, als an übrigen Bereichen des Rohrs. Unter Zugspannung ist derselbe Bereich geneigt, abzuflachen.

Figur 1b zeigt beispeilhaft ein Rohr 1 mit einem im Bereich 1b verringerten Durchmesser, der auch als umlaufende Einbuchtung oder Sicke verstanden werden kann. Das Rohr weist ebenfalls eine einfache Wellenform auf, die je nach Betrachtung an der oberen oder an der unteren Stirnseite des Rohrs mit einem größeren Rohrdurchmesser als die Sicke beginnt. Die Wandstärke des Rohrs ist vorzugsweise konstant oder wird vorzugsweise so konstant wie möglich ausgeführt. Die Bereiche des Rohrs neben der umlaufenden Einbuchtung 1b können mittels des bereits genannten Innendruck-Umformverfahrens erzeugt werden. Die Einbuchtung umläuft das Rohr vorzugsweise ganz. Am Scheitelbereich der gezeigten Welle, d.h. in dem Bereich, in dem das Rohr seinen kleinsten Durchmesser aufweist, ist das Rohr unter mechanischer Druckspannung geneigt, leichter einzubiegen bzw. geringfügig nachzugeben, als an übrigen Bereichen des Rohrs. Unter Zugspannung ist derselbe Bereich geneigt, abzuflachen.

Figur 2 zeigt erfindungsgemäβ ein Rohr 1 mit einer Wellenform, wobei die Wandstärke des Rohrs variiert, d.h., nicht konstant gehalten ist. Einbuchtungen des Rohrs bzw. Tiefen der Wellenform könnten dabei durch Materialabtrag wie beispielsweise mittels Fräsen gebildet sein. Im Bereich einer jeden Einbuchtung bzw. Wellentiefe weist das Rohr 1 eine geringere Wandstärke auf als in einem einbuchtungslosen Bereich des Rohrs. Ein Bereich des Rohrs mit reduzierter Wandstärke könnte derart abgemessen sein, dass eine gewünschte, insbesondere reduzierte Federsteifigkeit erreicht wird.

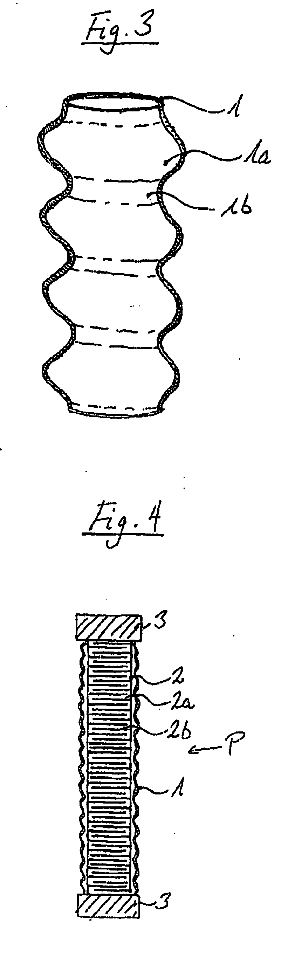

Figur 3 zeigt beispielhaft ein Wellrohr 1, welches beispielsweise mittels Innenhochdruck-Umformen eines unprofilierten bzw. glatten Rohrs hergestellt werden kann. Auch könnte das Rohr mittels Fließpressen oder Tiefziehen hergestellt werden. Nach einer Ausführungsform könnte das Wellrohr gemeinsam mit einem Boden als Fussplatteneinheit hergestellt sein.

Figur 4 zeigt ein in einem Wellrohr 1 angeordnetes piezoelektrisches Vielschichtbauelement 2, welches keramische Schichten 2a und Elektrodenschichten 2b aufweist. Die Anordnung ist Bestandteil eines Piezoaktors P. Das Vielschichtbauelement ist zwischen zwei stirnseitig angeordneten Gegenlagern 3 eingeklemmt, die auch direkt mit dem Wellrohr verbunden sind, beispielsweise mittels Verschweißen. Zusammen mit dem Wellrohr 1 setzen sie das Vielschichtbauelement 2 unter Druckspannung. Durch die Gegenlager 3 könnten elektrische Zuleitungen, die mit den Elektrodenschichten 2b kontaktiert sind, geführt sein.

Das verschiedenartig ausführbare Verspannelement mit einem rohrförmigen Körper kann zu seiner Festigkeitssteigerung kaltverfestigt werden.

Der rohrförmige Körper kann grundsätzlich eine Wellenform aufweisen, die sich durch wendelförmige Ausbuchtungen bzw. Einbuchtungen ergibt. Gegenüber den gezeigten Wellenformen hätten diese eine leichte Schräglage. Ein solcher rohrförmiger Körper könnte beispielsweise durch ein Herstellungsverfahren erzeugt werden, welches auch zum Formen von Gewinden geeignet ist.

### Bezugszeichenliste

- 1: Wellrohr
- 1a: ausgebeulter Bereich des Wellrohrs
- 1b: eingebuchteter Bereich des Wellrohrs
- 2: piezoelektrisches Vielschichtbauelement
- 2a: keramische Schichten
- 2b: Elektrodenschichten
- 3: Gegenlager
- P: Piezoaktor

## Patentansprüche

1. Verspannelement zur Verspannung eines piezoelektrischen Vielschichtbauelements (2), umfassend einen rohrförmigen Körper (1), der einen wellenförmigen Bereich aufweist, **dadurch gekennzeichnet, dass** die Dicke des rohrförmigen Körpers (1) variiert ausgeführt ist.

2. Verspannelement nach Anspruch 1, bei dem der rohrförmige Körper (1) ein Wellrohr ist.

3. Verspannelement nach einem der Ansprüche 1 oder 2, bei dem der wellenförmige Bereich gerade Abschnitte aufweist.

4. Verspannelement nach einem der vorhergehenden Ansprüche, bei dem der wellenförmige Bereich gekrümmte Abschnitte aufweist.

5. Verspannelement nach einem der vorhergehenden Ansprüche, bei dem der wellenförmige Bereich kontinuierlich verlaufende Wellen aufweist.

6. Verspannelement nach einem der vorhergehenden Ansprüche, bei dem der rohrförmige Körper (1) unterschiedliche queraxiale Innendurchmesser aufweist.

7. Verspannelement nach einem der vorhergehenden Ansprüche, bei dem der Innendurchmesser des rohrförmigen Körpers (1) konstant ist.

8. Piezoaktor (P) mit einem Verspannelement nach einem der vorhergehenden Ansprüche, bei dem ein piezoelektrisches Vielschichtbauelement (2) im rohrförmigen Körper (1) enthalten ist, wobei der rohrförmige Körper das Vielschichtbauelement unter eine axiale Druckspannung setzt.

9. Piezoaktor nach Anspruch 8, bei dem das piezoelektrische Vielschichtbauelement (2) stirnseitig mit je einem Gegenlager (3) mechanisch verbunden ist.

10. Piezoaktor nach Anspruch 9, bei dem der rohrförmige Körper (1) mit den Gegenlagern (3) mechanisch verbunden ist.

11. Piezoaktor nach einem der Ansprüche 8 bis 10, bei dem das piezoelektrische Vielschichtbauelement (2) Innenelektroden (2b) aufweist, die mit elektrischen zuleitungen des Piezoaktors kontaktiert sind.

## Claims

1. Bracing element for bracing a piezoelectric multilayer component (2), comprising a tubular body (1) which has a corrugated area, **characterized in that** the thickness of the tubular body (1) is designed in a varied manner.

2. Bracing element according to Claim 1, wherein the tubular body (1) is a corrugated tube.

3. Bracing element according to either of Claims 1 and 2, wherein the corrugated area has straight portions.

4. Bracing element according to one of the preceding claims, wherein the corrugated area has curved portions.

5. Bracing element according to one of the preceding claims, wherein the corrugated area has continuously running corrugations.

6. Bracing element according to one of the preceding claims, wherein the tubular body (1) has different axially transverse internal diameters.

7. Bracing element according to one of the preceding claims, wherein the internal diameter of the tubular body (1) is constant.

8. Piezo actuator (P) with a bracing element according to one of the preceding claims, wherein a piezoelectric multilayer component (2) is present in the tubular body (1), the tubular body placing the multilayer component under an axial compressive stress.

9. Piezo actuator according to Claim 8, wherein the piezoelectric multilayer component (2) is mechanically connected to an abutment (3) at each front face.

10. Piezo actuator according to Claim 9, wherein the tubular body (1) is mechanically connected to the abutments (3).

11. Piezo actuator according to one of Claims 8 to 10, wherein the piezoelectric multilayer component (2) has inner electrodes (2b) which are contact-connected with electrical feed lines of the piezo actuator.

## Revendications

1. Elément de serrage destiné à serrer un composant piézoélectrique multicouche (2) et comprenant un corps tubulaire (1) doté d'une partie ondulée, **caractérisé en ce que** l'épaisseur du corps tubulaire (1) est dessinée d'une façon variée.

2. Elément de serrage selon la revendication 1, dans lequel le corps tubulaire (1) est un tube ondulé.

3. Elément de serrage selon l'une des revendications 1 ou 2, dans lequel la partie ondulée présente des parties rectilignes.

4. Elément de serrage selon l'une des revendications précédentes, dans lequel la partie ondulée présente des parties incurvées.

5. Elément de serrage selon l'une des revendications précédentes, dans lequel la partie ondulée présente des ondulations continues.

6. Elément de serrage selon l'une des revendications précédentes, dans lequel le corps tubulaire (1) présente différents diamètres intérieurs transversalement à l'axe.

7. Elément de serrage selon l'une des revendications précédentes, dans lequel le diamètre intérieur du corps tubulaire (1) est constant.

8. Piézoactionneur (P) doté d'un élément de serrage selon l'une des revendications précédentes, dans lequel un composant piézoélectrique multicouche (2) est repris dans le corps tubulaire (1), le corps tubulaire plaçant le composant multicouche sous une contrainte de compression axiale.

9. Piézoactionneur selon la revendication 8, dans lequel le composant piézoélectrique multicouche (2) est relié mécaniquement à un contre-appui (3) sur chacun de ses côtés frontaux.

10. Piézoactionneur selon la revendication 9, dans lequel le corps tubulaire (1) est relié mécaniquement aux contre-appuis (3).

11. Piézoactionneur selon l'une des revendications 8 à 10, dans lequel le composant piézoélectrique multicouche (2) présente des électrodes intérieures (2b) mises en contact avec des conducteurs électriques du piézoactionneur.
